Europäisches Patentamt

European Patent Office

Office européen des brevets

(11) Publication number: 0 221 496
A2

# EUROPEAN PATENT APPLICATION

(21) Application number: 86114966.4

(51) Int. Cl.4: H01L 25/08 , H01L 23/48

(22) Date of filing: 28.10.86

(30) Priority: 04.11.85 US 794899

(43) Date of publication of application:
13.05.87 Bulletin 87/20

(84) Designated Contracting States:
DE FR GB

(71) Applicant: International Business Machines
Corporation
Old Orchard Road
Armonk, N.Y. 10504(US)

(72) Inventor: Overfield, Richard Blewer
8404 Antero Drive
Austin Texas 78759(US)
Inventor: Singh, Pratap
2901 Great Oaks Drive
Round Rock Texas 78681(US)

(74) Representative: Atchley, Martin John
Waldegrave
IBM United Kingdom Limited Intellectual
Property Department Hursley Park
Winchester Hampshire SO21 2JN(GB)

(54) Integrated circuit package.

(57) The present invention relates to an integrated circuit package of the type which comprises a lead frame (11) formed with a plurality of connecting leads (12) and two substantially identical integrated circuit chips (13, 15) mounted on the lead frame.

An integrated circuit package in accordance with the invention is characterised in that one integrated circuit chip (13) is mounted on one side of the frame, the other integrated circuit chip (15) is mounted on the other side of the frame, and each pair of corresponding terminals (14, 16) of the two integrated circuit chips are connected to the same connecting lead (12) of the frame.

FIG. 1

# INTEGRATED CIRCUIT PACKAGE

This invention relates to integrated circuit packages including integrated circuit chips.

With the explosive growth in recent years of data processing installations, particularly so called personal computers, there has been a need to package more and more data processing power and function. into smaller and smaller packages. Increased density in integrated circuit semiconductor chips has resulted in more data processing power for a given volume of packaged device. For example, 256K bit dynamic random access memory packages are now available in modules which are physically no larger than the 64K bit packages commonly used only a few years ago. Nevertheless, the search continues for ever smaller packaging techniques to continue to reduce the total size of data processing systems.

The dual inline pin integrated circuit package, known in the industry as the DIP package, is found in most data processing systems. US-A-4,398,235 shows an arrangement whereby a plurality of these integrated circuits is stacked in a piggyback fashion with the appropriate pins electrically connected together and other pins cut off. This approach is particularly useful in increasing random access and read only memory density. Of course, the space requirements for the increased height of the printed circuit card on which these devices are piggybacked must be greater than for a card populated with non-piggybacked modules, but the area requirements for the card do not increase.

US-A-3,746,934 discloses a stacked arrangement of integrated circuit chips which includes a stack of frames, each formed with connecting leads and known as a lead frame, with integrated circuit chips mounted on one side only of each lead frame. The lead frames are then electrically interconnected and the entire arrangement may then be appropriately encapsulated. Since there must be separation between the plurality of lead frames in this package, like the piggyback arrangement described above, this package has a height dimension which is nearly equal to its multiple of circuit density.

US-A-4,423,468 shows a package in which associated miniature electronic components, such as a bare micro processor and its associated unpackaged read only memory chip, are mounted on opposite sides of an insulating substrate which, in effect, amounts to a miniature, double sided printed circuit card. Wire bonding connects the contact points on the semiconductor chips to conductive patterns on the insulating substrate. The insulating substrate is then sealed by insulating covers on each side of the substrate and the entire assembly may be reflow soldered to external circuitry as a surface mounted component module. While this technique is yet another approach to increasing the density of mounted integrated circuit chips, it is a rather complex arrangement which is equivalent to a double sided printed circuit card having bare chips mounted thereon and being further enclosed in a protective case. Although such an approach does yield higher circuit densities, its complexity leads to substantially higher costs.

It would, therefore, be highly desirable to achieve greatly increased circuit densities in a low cost, easily manufactured first level package for integrated circuit chips.

The object of the present invention is to provide an improved integrated circuit package.

The present invention relates to an integrated circuit package of the type which comprises a lead frame formed with a plurality of connecting leads and two substantially identical integrated circuit chips mounted on the lead frame.

An integrated circuit package in accordance with the invention is characterised in that one integrated circuit chip is mounted on one side of the frame, the other integrated circuit chip is mounted on the other side of the frame, and each pair of corresponding terminals of the two integrated circuit chips are connected to the same connecting lead of the frame.

The double integrated circuit chip package according to the invention is slightly thicker than a conventional module which allows integrated circuit chips to be mounted on only one side of the lead frame. A packaging arrangement according to the invention yields a package substantially smaller than the piggybacked module or stacked lead frame approach described in the prior art above. The arrangement also utilises substantially lower cost materials and manufacturing techniques than are required by the enclosed double sided printed circuit board configuration described above, for example, because no substrate or through holes plated therethrough are required. For a given sized integrated circuit memory chip, the memory density per given area on a printed circuit card can be doubled with less additional component height than with the prior art techniques.

In order that the invention may be more readily understood an embodiment will now be described with reference to the accompanying drawings, in which:

Fig. 1 shows a cross sectional view of a DIP package incorporating the integrated circuit chip packaging technique of this invention, and

Figs. 2 & 3 show opposite sides of a package incorporating the integrated circuit chip packaging technique of this invention.

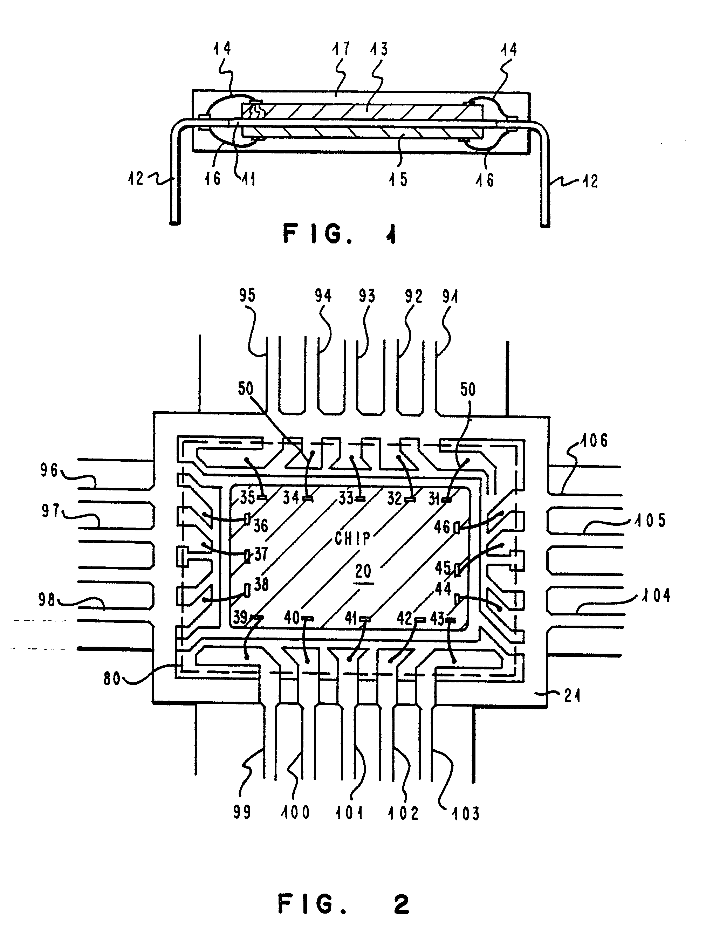

Referring now to Fig. 1, a lead frame 11 is shown having a plurality of connecting leads 12 extending therefrom. A semiconductor integrated circuit memory chip 13 is attached to the top side of the lead frame 11 and a plurality of wire bonds 14 electrically connect appropriate circuit termination points on the integrated circuit chip 13 to the correspondingly appropriate ones of the leads 12. Also mounted to the opposite side of the lead frame 11 is another integrated circuit memory chip 15. The circuits on the two memory chips 13 and 15 are identical; however, the circuit termination points on the memory chip 15 are physically located in a mirror image configuration compared with the corresponding circuit termination points on the memory chip 13. Because of this arrangement of circuit termination points on the memory chip 15, the placement of another set of wire bonds 16 from the circuit termination points on the memory chip 15 to the plurality of leads 12 is a mirror image of the configuration of the plurality of wire bonds 14 and each pair of corresponding termination points on the two chips 13, 15 are connected to the same lead 12.

The technologies of the lead frame 11, the attachment of the chips 13 and 15 thereto, and the wire bonding to make electrical connections between the circuit termination points on the chips 13 and 15 with the appropriate connecting leads 12 are well known in the art and include numerous alternatives.

After this subassembly is constructed, the subassembly is typically encapsulated in a suitable plastic material 17, as shown in Fig. 1.

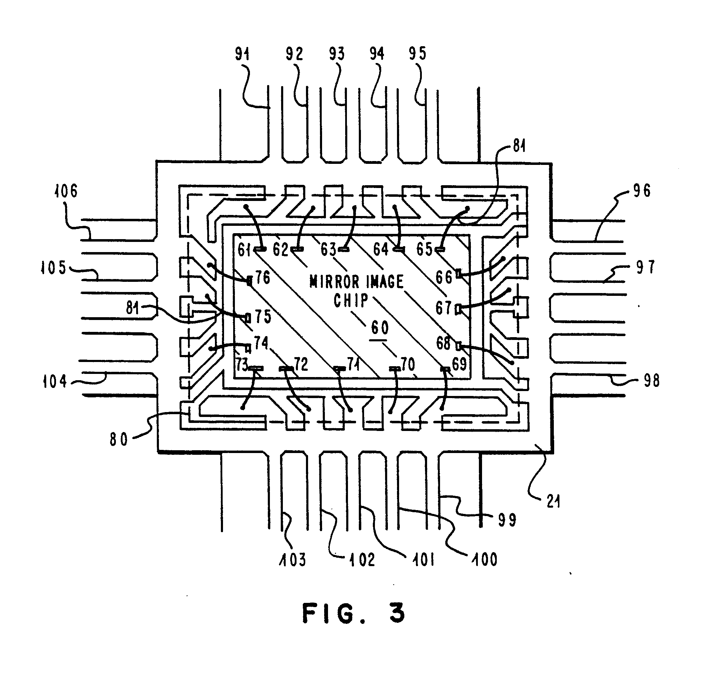

Referring now to Figs. 2 and 3, views of opposite sides of another type of integrated circuit memory package are shown. When completed, the package shown in Figs. 2 and 3 will be a plastic leaded chip carrier or PLCC. Such a package is suited for surface mounting without leads that extend through holes in a printed circuit board. The partially completed package shown in Figs. 2 and 3 differs from the DIP package in Fig. 1 in that the package of Figs. 2 and 3 has leads extending from four sides thereof instead of the leads extending from the two sides of a DIP package.

In Fig. 2 a semiconductor integrated circuit memory chip 20 is suitably attached to the central portion of a lead frame 21. The lead frame 21 has a plurality of connecting leads 91-106 extending therefrom which, at this stage of the manufacture of the package, are all physically and electrically connected together by the metal of the lead frame which will be cut later in the manufacturing process. A plurality of circuit termination points 31-46 on chip 20 are connected by a plurality of wire bonds 50 to the individual portions of the lead frame 21 which will comprise the leads 91-106.

Consider now an imaginary vertical axis extending in the plane of the Figure about which the subassembly shown in Fig. 2 is rotatable. Fig. 3 shows a view of this subassembly after a 180 degree rotation about this imaginary vertical axis. In Fig. 3 another integrated circuit memory chip 60 is attached to the central portion of an opposite side of the same lead frame 21. It will be noted that the circuit termination points on chip 60 are a mirror image of the corresponding circuit termination points on chip 20. That is, the sets of circuit termination points, starting with the lowest numbered circuit termination point and ending with the highest numbered circuit termination point on each of the chips 20 and 60 are mirror images of each other. Accordingly, the lowest numbered circuit termination points 31 (on chip 20) and 61 (on chip 60) are connected by wire bonds to the same connecting lead (91) on the lead frame 21 and the other pairs of corresponding termination points on the two chips are connected to the same connecting lead.

The dashed line 80 in each of Figs. 2 and 3 represents the mould outline for encapsulation of the subassembly in a suitable material. After each of the wire bonds 50, connecting chip 20 to the lead frame 21, and wire bonds 81, connecting chip 60 to the lead frame 21, have been made, an appropriate encapsulation material is formed around the subassembly by conventional processes such as moulding. Excess portions of the lead frame are then cut away and the leads are appropriately formed for the desired package.

In summary, a technique has been shown and described for mounting a first integrated circuit chip on one side of a lead frame and complementing this subassembly by the addition of a mirror image second integrated circuit chip mounted on the opposite side of the lead frame. This assembly is then encapsulated in an appropriate material, such as plastic. Memory chips are especially suitably for this mounting technique, which is adaptable to pinned, leaded, and surface mount integrated circuit packages.

Those skilled in the art will recognise that the arrangement described has application in a wide variety of packaging techniques including DIP packages, plastic leaded chip carriers for surface mounting, etc. A variety of techniques may also be employed for attaching the chips to the lead frames or equivalents thereof. For example, flip chip bonding may be employed, wherein the chip is oriented so that the circuit connection points contact and are bonded to the lead frame fingers through reflow or gold bump ultrasonic bonding.

## Claims

1. An integrated circuit package comprising a lead frame (11; 21) formed with a plurality of connecting leads (12; 91....106) and two substantially identical integrated circuit chips (13, 15; 20,60) mounted on said lead frame, characterised in that one integrated circuit chip (13; 20) is mounted on one side of said frame, the other integrated circuit chip (15;60) is mounted on the other side of said frame, and each pair of corresponding terminals - (14,16; 31,61....36,76) of the two integrated circuit chips are connected to the same connecting lead - (12; 91....106) of said frame.

2. An integrated circuit package as claimed in claim 1 characterised in that each integrated circuit chip comprises a pattern of circuit connection points which is substantially a mirror image of the pattern of circuit connection points on the other integrated circuit chip.

3. An integrated circuit package as claimed in claim 1 characterised in that it comprises an encapsulating plastic material (17) enclosing said integrated circuit chips and a portion of said lead frame.

4. An integrated circuit package as claimed in any one of the preceding claims characterised in that one integrated circuit chip comprises a first memory chip.

5. An integrated circuit package as claimed in claim 4 characterised in that the other integrated circuit chip comprises a second memory chip.

6. An integrated circuit package as claimed in any one of the preceding claims characterised in that said lead frame includes a plurality of leads adapted for insertion into holes of a printed circuit card.

7. An integrated circuit package as claimed in any one of the preceding claims 1 to 5 characterised in that said lead frame includes a plurality of leads adapted for surface connection to conductive portions of a printed circuit card.

F I G. 1

F I G. 2

FIG. 3